(19) Europäisches Patentamt
European Patent Office
Office européen des brevets

(11) **EP 4 708 668 A1**

(12) **EUROPEAN PATENT APPLICATION**

(43) Date of publication:
**11.03.2026 Bulletin 2026/11**

(21) Application number: **24306478.9**

(22) Date of filing: **10.09.2024**

(51) International Patent Classification (IPC):
**H02P 21/13** *(2006.01)* **H02P 29/024** *(2016.01)*
**H02P 29/028** *(2016.01)*

(52) Cooperative Patent Classification (CPC):
**H02P 21/13; H02P 29/024; H02P 29/028**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **NXP B.V.**
**5656 AG Eindhoven (NL)**

(72) Inventors:
• **Santiago, Erik**
**31023 Toulouse Cedex 1 (FR)**
• **Dietsch, Jérôme**
**31023 Toulouse Cedex 1 (FR)**
• **Viet-Long, Bui-Tuan**
**31023 Toulouse Cedex 1 (FR)**

(74) Representative: **Schmütz, Christian Klaus
Johannes
NXP Semiconductors Germany GmbH
Intellectual Property Group
Beiersdorfstr. 12
22529 Hamburg (DE)**

(54) **LINEAR PARAMETER-VARYING OBSERVER FOR ESTIMATING PHASE CURRENT OF AN ELECTRIC MOTOR CONTROLLER**

(57) A linear parameter-varying (LPV) observer for an electric motor controller. The controller includes a control loop with a current sensor that senses phase current signals driving an electric motor and that provides sensed current values used in the control loop. The observer includes an input interface and a processor. The input interface provides a sensed angular speed value, a sensed angular position value, physical parameters of the electric motor, and a pair of control loop control voltages used in the control loop. The processor calculates estimated current values indicative of the sensed current values using the angular speed value, the angular position value, the pair of control voltages, and the electric motor physical parameters. A failure detector may compare the sensed current values with the estimated current values to detect a failure, and substitute the estimated current signals for the sensed current signals when a failure is detected.

FIG. 1

EP 4 708 668 A1

**Description**

BACKGROUND

FIELD

The present disclosure relates in general to electric motor control, and more particularly to a system and method of estimating the phase current signal(s) feeding a permanent magnet synchronous motor (PMSM) by a linear parameter-varying observer that estimates phase current values used to replace sensed current values in the event of current sensor failure.

DESCRIPTION OF THE RELATED ART

Permanent magnet synchronous motor (PMSM) drives are receiving significant attention for many industrial applications due to their fast control response, high power density, and high efficiency. PMSM drives typically include a current sensor that senses a three-phase current signal which provides essential information for the Field-oriented control (FOC), direct-torque control (DTC) used in PMSM motor control systems. A failure of the current sensor will affect the operation of the PMSM motor control system. It has proven difficult to identify a faulty current sensor and to estimate the three-phase current signal during operation. Conventional sensor failure detection algorithms are usually developed with a view to specific types of sensor faults that are not comprehensive in terms of failure detection. In addition, the sensor failure may not be automatically detectable in output feedback closed-loop current control systems. Conventional observers for estimating the current signal, such as a Luenberger observer or a linear observer or the like, have proved inadequate in terms of detection and performance.

BRIEF DESCRIPTION OF THE DRAWINGS

Embodiments of the present invention are illustrated by way of example and are not limited by the accompanying figures. Similar references in the figures may indicate similar elements. Elements in the figures are illustrated for simplicity and clarity and have not necessarily been drawn to scale.

FIG. 1 is a simplified block diagram of a motor control system including a reconfiguration system with a linear parameter-varying (LPV) observer implemented according to one embodiment.

FIG 2 is a structural block diagram of the LPV observer of FIG. 1 according to one embodiment for calculating the estimated current values from sensed angular position and speed values and loop control voltage values.

FIG. 3 is a simplified block diagram of the failure detector of FIG. 1 implemented according to one embodiment.

DETAILED DESCRIPTION

The present disclosure describes a linear parameter-varying (LPV) observer that estimates phase current values that correspond with phase current signals driving a permanent magnet synchronous motor (PMSM) using reference control loop voltages along with angular position and angular velocity signals from a resolver sensor interfaced with the motor. A three-phase converter generates the phase current signals that drive the motor, and a current sensor senses the phase currents and provides sensed phase current signals to a feedback loop used to control the converter. The sensed phase current signals are converted to "sensed" current values that are further converted to feedback current values used in the control loop. The estimated current values provided by the LPV observer are determined independently of the sensed phase current signals. If the current sensor is damaged, a failure detector detects the failure and replaces the sensed current values with the estimated current values to maintain operation. The failure detector may be configured to compare the sensed current values with the estimated current values to detect the failure of current sensor.

Adapting to angular position and speed parameters provided by an angular speed and position sensor and to reference control loop voltages, the LPV observer estimates the nonlinear observer gains to increase the performance and robustness of the estimated current values. The disclosed LPV observer ensures good estimation of the effects of frequency disturbances and uncertain inputs. The estimated current values determined by the LPV observer may be used by the failure detector to detect failure of the current sensor and to replace the damaged current values with the estimated current values. The disclosed LPV observer ensures stability and reliability in diagnosing sensor failures as well as feasibility in fault tolerance control.

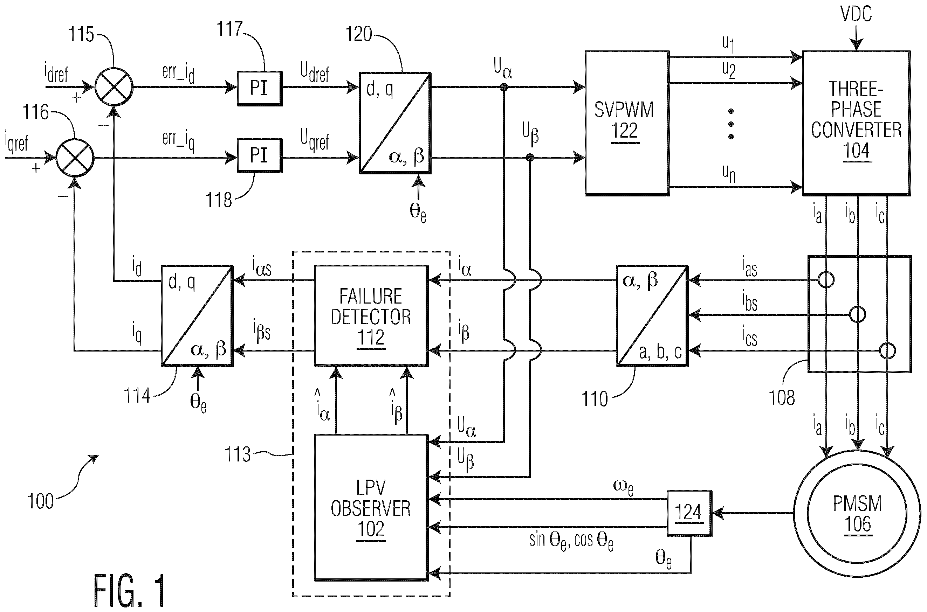

FIG. 1 is a simplified block diagram of a motor control system 100 including a reconfiguration system 113 with a linear parameter-varying (LPV) observer 102 implemented according to one embodiment. The motor control system 100 may be used for any one of many different types of industrial applications, such as, for example motor drives, electric vehicle (EV) drives, flexible alternating-current (AC) transmission and distribution devices, etc. The motor control system 100 includes a three-phase converter 104 configured to convert a direct-current voltage (VDC) into 3 three-phase control current signals $i_a$, $i_b$, and $i_c$ for controlling a three-phase motor 106, such as, for example, a permanent magnet synchronous machine (PMSM) or the like. A current sensor 108 senses the three-phase current signals $i_a$, $i_b$, and $i_c$ provided to the motor 106 and provides sensed phase current signals $i_{as}$, $i_{bs}$, and $i_{cs}$, respectively. The phase current signals of the motor provide essential information for the field-oriented control (FOC), direct-torque control (DTC) often used in PMSM motor control systems. As further described herein, the LPV observer 102 is configured to reliably estimate current values based on the three-phase current signals using reference control loop voltages along with angular position and angular velocity signals from an angular speed and position sensor 124 interfaced with the motor 106. In addition, a failure detector 112 identifies and diagnoses a failure of the current sensor 108, and in the event of failure, replaces the sensed current values with corresponding estimated current values from the LPV observer 102.

The failure detector 112 and the LPV observer 102 are collectively referred to as the reconfiguration system 113. In this manner, the reconfiguration system 113 is configured to calculate estimated current values from control voltage information and information provided by the angular speed and position sensor 124, to compare the sensed current values with the estimated current values for detecting failure of the current sensor, and to replace the sensed current values with the estimated current values in the event of a failure as further described herein.

The sensed three-phase current signals $i_{as}$, $i_{bs}$, and $i_{cs}$ are provided to respective inputs of a Clarke transformation converter 110, which performs a 3-phase to 2-phase transformation to convert the three-phase balanced current signals into $\alpha\beta$-axis stationary stator current values $i_\alpha$ and $i_\beta$. Although the $\alpha\beta$-axis stationary stator current values $i_\alpha$ and $i_\beta$ are not directly sensed, they are nonetheless referred to herein as "sensed" current values since derived from the sensed three-phase current signals $i_{as}$, $i_{bs}$, and $i_{cs}$. The sensed current values $i_\alpha$ and $i_\beta$ are provided to respective inputs of the failure detector 112, which, during normal operation, forwards the sensed current values $i_\alpha$ and $i_\beta$ substantially unmodified as corresponding stator current values $i_{\alpha s}$ and $i_{\beta s}$, respectively. The stator current values $i_{\alpha s}$ and $i_{\beta s}$ are provided to respective inputs of a Park transformation converter 114, which performs a stationary-to-rotating transformation from the $\alpha\beta$-axis to dq-axis rotational currents $i_d$ and $i_q$ provided as feedback current control values. The Park transformation converter 114 may use an angular position value $\theta_e$ provided by the angular speed and position sensor 124 for performing the transformation.

The motor control system 100 further includes a pair of adders 115 and 116 that compare input reference current values with the feedback current control values for controlling motor operation. The adder 115 subtracts the feedback current control value $i_d$ from a direct axis current reference value $i_{dref}$ (which may be set to zero) to provide an error value err_$i_d$, and the adder 116 subtracts feedback current control value $i_q$ from a quadrature axis current reference value $i_{qref}$ to provide an error value err_$i_q$. It is noted that $i_{qref}$ may be a quadrature reference value proportional to a desired output torque of the motor 106. The error values err_$i_d$ and err_$i_q$ are provided to respective inputs of a pair of proportional-integral (PI) controllers 117 and 118, which convert the error values into stator reference direct and quadrature voltages $U_{dref}$ and $U_{qref}$ values, respectively. The $U_{dref}$ and $U_{qref}$ stator reference voltages are provided to respective inputs of an inverse Park transformation converter 120, which performs a rotating-to-stationary transformation from the dq-axis to $\alpha\beta$-axis (which may also the angular position value $\theta_e$ provided by the angular speed and position sensor 124) to provide corresponding control voltages $U_\alpha$ and $U_\beta$, respectively. The control voltages $U_\alpha$ and $U_\beta$ are provided to respective inputs of a space vector pulse-width modulation (SVPWM) modulator 122, which uses the control voltages $U_\alpha$ and $U_\beta$ to generate a set of "n" PWM switch drive signals $u_1$, $u_2$, ... $u_n$ to control corresponding power switches (not shown) within phase circuits of the three-phase converter 104 for generating the three-phase current signals $i_a$, $i_b$, and $i_c$.

The angular speed and position sensor 124, which is either incorporated within or otherwise interfaced with the motor 106, senses an angular speed value $\omega_e$ and the angular position value $\theta_e$ and determines a pair of position values $\sin \theta_e$ and $\cos \theta_e$. The sine and cosine position values are trigonometric functions of the angular position value $\theta_e$, which may also be referred to as the scheduling parameter, is the angle of the synchronously rotating frame of the motor 106. The control voltages $U_\alpha$ and $U_\beta$ and the sensed angular speed and position values $\omega_e$, $\sin \theta_e$, and $\cos \theta_e$ are provided to respective inputs of the LPV observer 102, which calculates a pair of estimated current values $\hat{i}_\alpha$ and $\hat{i}_\beta$ provided to additional inputs of the failure detector 112. It is noted that a hat symbol "^" positioned above a value or variable represents an estimation of that value or variable. In operation, the failure detector 112 compares any residual between the sensed current values $i_\alpha$ and $i_\beta$ and the estimated current values $\hat{i}_\alpha$ and $\hat{i}_\beta$, respectively, to identify any fault condition of the sensed values. When a fault is detected, such as any significant deviation of the sensed current values $i_\alpha$ and $i_\beta$ relative to the estimated current values $\hat{i}_\alpha$ and $\hat{i}_\beta$, the failure detector 112 replaces the sensed current values $i_\alpha$ and $i_\beta$ with the estimated current values $\hat{i}_\alpha$ and $\hat{i}_\beta$, respectively, as the stator current signals $i_{\alpha s}$ and $i_{\beta s}$ provided to the Park transformation converter 114 to maintain operation.

The operation of the LPV observer 102 may be represented as a mathematical model in the stationary reference frame of the motor control system 100 presented with both electrical and mechanical portions. The estimated current value

$\hat{\imath}_\alpha$ may be described according to the following equation (1):

$$\frac{d}{dt}\hat{\imath}_\alpha = -\frac{R_s}{L_s}\hat{\imath}_\alpha + \frac{p}{L_s}\phi_m \sin\theta_e\,\widehat{\omega}_e + \frac{1}{L_s}U_\alpha(t) + K(\theta_e)_{[1]}\Delta_{\omega_e,\theta_e} \quad (1)$$

where dx/dt denotes a derivative function of a variable x (e.g., $\hat{\imath}_\alpha$), Rs is a stator winding resistance and $L_S$ is a stator winding inductance of the motor 106, p is a pole pairs number, $\phi_m$ is a flux leakage of the motor 106, $\widehat{\omega}_e$ is an estimation of the angular speed value $\omega_e$, $K(\theta_e)$ is a matrix value dependent upon $\sin\theta_e$ and $\cos\theta_e$, or $K(\theta_e) = K_1\sin\theta_e + K_2\cos\theta_e + K_3$ where $K_1$, $K_2$, and $K_3$ are gain values, $K(\theta_e)_{[i]}$ is the i-th row of matrix $K(\theta_e)$, and $\Delta_{\omega_e,\theta_e}$ is a difference value matrix. The difference value matrix $\Delta_{\omega_e,\theta_e}$ may be described according to the following equation (2):

$$\Delta_{\omega_e,\theta_e} = \left(\begin{bmatrix}\omega_e\\\theta_e\end{bmatrix} - \begin{bmatrix}\widehat{\omega}_e\\\widehat{\theta}_e\end{bmatrix}\right) = \begin{bmatrix}\omega_e - \widehat{\omega}_e\\\theta_e - \widehat{\theta}_e\end{bmatrix} \quad (2)$$

where $\hat{\theta}_e$ is an estimation of the angular position value $\theta_e$. The estimated current value $\hat{\imath}_\alpha$ may be determined by integrating the derivative function according to the following equation (3):

$$\hat{\imath}_\alpha = \int\frac{d}{dt}\hat{\imath}_\alpha \quad (3)$$

In a similar manner, the estimated current value $\hat{\imath}_\beta$ may be described according to the following equation (4):

$$\frac{d}{dt}\hat{\imath}_\beta = -\frac{R_s}{L_s}\hat{\imath}_\beta - \frac{p}{L_s}\phi_m\cos\theta_e\,\widehat{\omega}_e + \frac{1}{L_s}U_\beta(t) + K(\theta_e)_{[2]}\Delta_{\omega_e,\theta_e} \quad (4)$$

where the estimated current value $\hat{\imath}_\beta$ may be determined by integrating the derivative function according to the following equation (5):

$$\hat{\imath}_\beta = \int\frac{d}{dt}\hat{\imath}_\beta \quad (5)$$

The estimated current values $\hat{\imath}_\alpha$ and $\hat{\imath}_\beta$ may be presented in vector form according to the following equation (6):

$$\frac{d}{dt}\begin{bmatrix}\hat{\imath}_\alpha\\\hat{\imath}_\beta\end{bmatrix} = -\frac{R_s}{L_s}\begin{bmatrix}\hat{\imath}_\alpha\\\hat{\imath}_\beta\end{bmatrix} + \frac{p}{L_s}\phi_m\begin{bmatrix}\sin\theta_e\\-\cos\theta_e\end{bmatrix}\widehat{\omega}_e + \frac{1}{L_s}\begin{bmatrix}u_\alpha(t)\\u_\beta(t)\end{bmatrix} + K(\theta_e)_{[1:2]}\left(\begin{bmatrix}\omega_e\\\theta_e\end{bmatrix} - \begin{bmatrix}\widehat{\omega}_e\\\widehat{\theta}_e\end{bmatrix}\right) \quad (6)$$

in which the estimated current values $\hat{\imath}_\alpha$ and $\hat{\imath}_\beta$ may be determined by integrating the derivative values according to the following equation (7):

$$\begin{bmatrix}\hat{\imath}_\alpha\\\hat{\imath}_\beta\end{bmatrix} = \int\frac{d}{dt}\begin{bmatrix}\hat{\imath}_\alpha\\\hat{\imath}_\beta\end{bmatrix} \quad (7)$$

The estimated angular speed value $\widehat{\omega}_e$ may be described according to the following equation (8):

$$\frac{d}{dt}\widehat{\omega}_e = -\frac{p}{J}\phi_m\sin\theta_e\,\hat{\imath}_\alpha + \frac{p}{J}\phi_m\cos\theta_e\,\hat{\imath}_\beta - \frac{F_v}{J}\widehat{\omega}_e + K(\theta_e)_{[3]}\Delta_{\omega_e,\theta_e} \quad (8)$$

where J is an inertia of rotor and load and $F_v$ is a coefficient of viscous friction of the motor 106. The estimated angular position value $\hat{\theta}_e$ may be described according to the following equation (9):

$$\frac{d}{dt}\hat{\theta}_e\widehat{\omega}_e + K(\theta_e)_{[4]}\Delta_{\omega_e,\theta_e} \quad (9)$$

The estimated values $\hat{\omega}_e$ and $\hat{\theta}_e$ may be determined by integrating the derivative values according to the following set of equations (10):

$$\hat{\omega}_e = \int \frac{d}{dt}\hat{\omega}_e \,,\, \hat{\theta}_e \cong \int \frac{d}{dt}\hat{\omega}_e \quad (10)$$

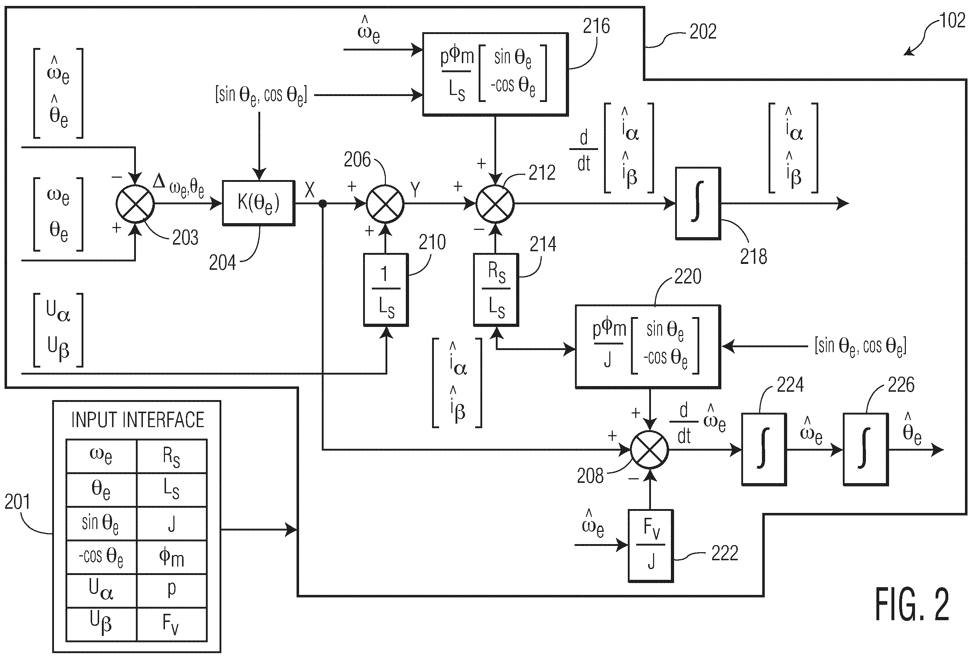

FIG. 2 is a structural block diagram of the LPV observer 102 according to one embodiment for calculating the estimated current values $\hat{i}_\alpha$ and $\hat{i}_\beta$ from the sensed values $\omega_e$, $\theta_e$, $\sin \theta_e$, $\cos \theta_e$, and the control voltage values $U(t) = U_\alpha$ and $U_\beta$ according to the preceding equations (1) through (10). The LPV observer 102 includes an input interface 201 and an LPV processor 202 that is configured to receive input values provided from the input interface 201 and to calculate or otherwise determine the estimated current values $\hat{i}_\alpha$ and $\hat{i}_\beta$. The LPV processor 202 includes various functional blocks as further described herein that may be configured using computational hardware or software or any suitable combination thereof.

The input interface 201 may be configured according to the types of input values received or stored. For example, the input interface 201 may include buffer or filter circuitry for receiving and forwarding the sensed values $\omega_e$, $\theta_e$, $\sin \theta_e$, $\cos \theta_e$, and the control voltage values $U(t) = U_\alpha$ and $U_\beta$. The input interface 201 may include calculation circuitry for calculating the $\sin \theta_e$ and $\cos \theta_e$ values based on $\theta_e$ for embodiments in which the angular speed and position sensor 124 only provides the $\theta_e$ value. The input interface 201 may further include memory devices, such as registers or the like, for storing digital values indicative of the constant physical parameters of the motor 106. The illustrated physical parameters of the motor 106 include the stator winding resistance Rs, the stator winding inductance $L_S$, the inertia of rotor and load J, the flux leakage $\phi_m$, and the coefficient of viscous friction $F_v$. The input interface 201 may receive or otherwise store a value indicative of the pole pairs number p.

The LPV processor 202 includes an input adder 203 along with additional adders 206, 212, and 208, gain blocks 204, 210, 214, 216, 220, and 222 in which gain blocks 216 and 220 are variable gain blocks, and integrators 218, 224, and 226. The input adder 203 subtracts calculated feedback parameters $[\hat{\omega}_e, \hat{\theta}_e]$ from the sensed input parameters $[\omega_e, \theta_e]$ and outputs the difference value matrix $\Delta\omega_e, \theta_e$ according to equation (2). The difference value matrix $\Delta\omega_e, \theta_e$ and the $\sin \theta_e$ and $\cos \theta_e$ values are provided to the gain block 204 incorporating the gain-scheduling value of the angular position $K(\theta_e)$. The gain block 204 outputs corresponding values X provided to inputs of the adders 206 and 208. The control voltages $U_\alpha$ and $U_\beta$ are provided to the gain block 210, which effectively divides each by $L_s$ to provide divided values to other inputs of the adder 206. The adder 206 adds the output of gain block 210 to the X values and outputs values Y to inputs of the adder 212. The estimated current values $\hat{i}_\alpha$ and $\hat{i}_\beta$ are both provided to inputs of the gain block 214 with gain $R_s/L_s$, which provides corresponding output values to other inputs of the adder 212. The parameter $\hat{\omega}_e$, is provided to an input of the variable gain block 216 having gain value $\frac{p\phi_m}{L_s}\begin{bmatrix} \sin \theta_e \\ -\cos \theta_e \end{bmatrix}$, in which the adder 212 adds Y to the output of the gain block 216 and subtracts the outputs of the gain block 214 and provides derivative values $d[\hat{i}_\alpha, \hat{i}_\beta]/dt$ to the integrator 218, which outputs the estimated current values $\hat{i}_\alpha$ and $\hat{i}_\beta$.

The estimated current values $\hat{i}_\alpha$ and $\hat{i}_\beta$ are also provided to the input of the variable gain block 220 with gain value $\frac{p\phi_m}{J}\begin{bmatrix} \sin \theta_e \\ -\cos \theta_e \end{bmatrix}$, which has corresponding outputs provided to other inputs of the adder 208. The parameter $\hat{\omega}_e$ is provided to the input of the gain block 222 having a gain of Fv/J and having an output provided to another input of the adder 208. The adder 208 adds X to the outputs of the gain block 220 and subtracts the output of the gain block 222 and provides a derivative output value $d(\hat{\omega}_e)/dt$ to an input of the integrator 224, which provides the estimated value $\hat{\omega}_e$. The estimated value $\hat{\omega}_e$ is provided to the input of the integrator 226 providing the estimated value $\hat{\theta}_e$. As previously described, one or both of the values $\hat{\omega}_e$ and $\hat{\theta}_e$ are fed back to various functional blocks including the input adder 203.

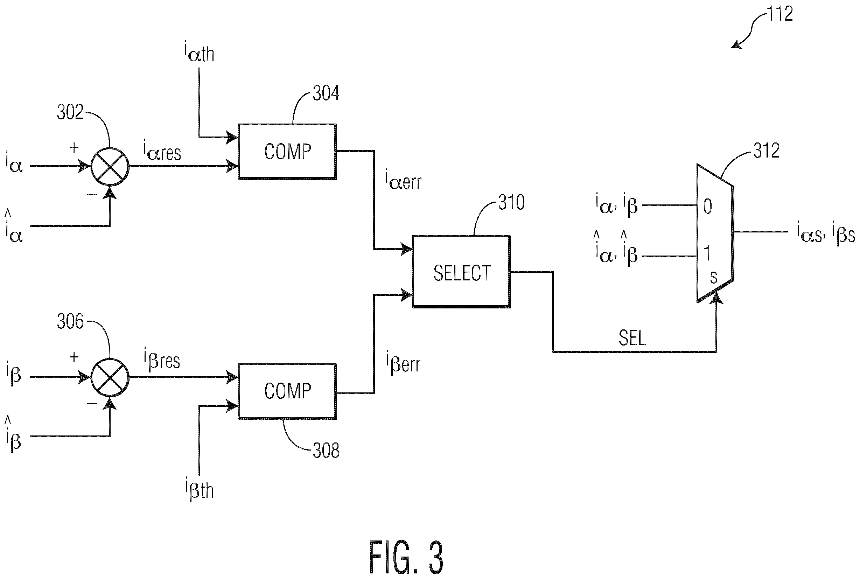

FIG. 3 is a simplified block diagram of the failure detector 112 implemented according to one embodiment. A first adder 302 subtracts the estimated current value $\hat{i}_\alpha$ from the sensed current value $i_\alpha$ and outputs a difference or residual value $i_{\alpha res}$. The residual value $i_{\alpha res}$ is provided to a first input of a comparator (COMP) 304, which receives a corresponding current threshold value $i_{\alpha th}$ at a second input and outputs a corresponding error value $i_{\alpha err}$. Similarly, a second adder 306 subtracts the estimated current value $\hat{i}_\beta$ from the sensed current value $i_\beta$ and outputs a difference or residual value $i_{\beta res}$. The residual value $i_{\beta res}$ is provided to a first input of another comparator 308, which receives a corresponding current threshold value $i_{\beta th}$ at a second input and outputs a corresponding error value $i_{\beta err}$. The error values $i_{\alpha err}$ and $i_{\beta err}$ are provided to respective inputs of a selector (SELECT) 310, which outputs a select value SEL to a select input of a multiplexer (MUX) 312. The MUX 312 has a first or logic "0" input receiving the sensed current values $i_\alpha$ and $i_\beta$, a second or logic "1" input receiving the estimated current values $\hat{i}_\alpha$ and $\hat{i}_\beta$, and an output providing the stator current signals $i_{\alpha s}$ and $i_{\beta s}$.

The estimated current values $\hat{i}_\alpha$ and $\hat{i}_\beta$ should be substantially equal to the sensed current values $i_\alpha$ and $i_\beta$, or at least within predetermined thresholds. The threshold value $i_{\alpha th}$ may be programmed to a value which represents an acceptable or expected deviation of $\hat{i}_\alpha$ with respect to $i_\alpha$, and the threshold value $i_{\beta th}$ may be programmed to a value which represents an acceptable or expected deviation of $\hat{i}_\beta$ with respect to $i_\beta$. When the magnitude of $i_{\alpha res}$ is less than or equal to $i_{\alpha th}$, then the comparator 304 asserts $i_{\alpha err}$ low indicating no error of the current sensor 108. When the magnitude of $i_{\alpha res}$ exceeds $i_{\alpha th}$, however, then the comparator 304 asserts $i_{\alpha err}$ high indicating an error of the current sensor 108. Similarly, when the magnitude of $i_{\beta res}$ is less than or equal to $i_{\beta th}$, then the comparator 304 asserts $i_{\beta err}$ low indicating no error of the current sensor 108. When the magnitude of $i_{\beta res}$ exceeds $i_{\beta th}$, however, then the comparator 304 asserts $i_{\beta err}$ high indicating an error of the current sensor 108.

During normal operation when the current sensor 108 is operating correctly, then $i_{\alpha err}$ and $i_{\beta err}$ are both asserted low and the selector 310 asserts SEL low so that the MUX 312 selects the sensed current values $i_\alpha$ and $i_\beta$ as the stator current signals $i_{\alpha s}$ and $i_{\beta s}$, respectively. When either one of the $i_{\alpha err}$ and $i_{\beta err}$ values is asserted high (or when both are asserted high) indicating a failure of the current sensor 108, then the selector 310 asserts SEL high so that the MUX 312 selects the estimated current values $\hat{i}_\alpha$ and $\hat{i}_\beta$ as the stator current signals $i_{\alpha s}$ and $i_{\beta s}$, respectively. In this manner, the failure detector 112 is configured to detect an error of the current sensor 108 based on residual deviations of the sensed current values from the estimated current values. When an error is detected, the failure detector 112 is configured to replace the sensed current values $i_\alpha$ and $i_\beta$ with the estimated current values $\hat{i}_\alpha$ and $\hat{i}_\beta$ provided by the LPV observer 102.

Although not explicitly shown, the failure detector 112 may be configured to compensate for any timing differential (e.g., lead or lag) between the estimated and sensed current values. In one embodiment, the magnitudes of the threshold values $i_{\alpha th}$ and $i_{\beta th}$ may be adjusted accordingly. In addition or in the alternative, a delay may be incorporated to delay the leading values to substantially match the timing of the lagging values in a given configuration. For example, if the estimated values are determined to lag behind the sensed values by a certain timing delay, then the sensed values may be delayed accordingly.

One or more embodiments of the present disclosure may include features recited in the following numbered clauses:

1. A reconfiguration system for an electric motor controller, the electric motor controller including a control loop with a current sensor configured to sense phase current signals driving an electric motor to provide sensed current values used for determining feedback current values that are used to determine control voltages in the control loop for generating the phase current signals, and an angular speed and position sensor that provides angular speed and position information of the electric motor, the reconfiguration system comprising:

a linear parameter-varying (LPV) observer including circuitry, the LPV observer configured to calculate estimated current values using the control voltages and the angular speed and position information; and

a failure detector including circuitry, the failure detector configured to compare the sensed current values with the estimated current values for detecting a failure, and to substitute the estimated current signals for the sensed current signals when a failure is detected.

2. The reconfiguration system of clause 1, wherein the LPV observer is configured to combine the control voltages and the angular speed and position information with physical constants of the electric motor and gain information to calculate the estimated current values.

3. The reconfiguration system of clause 2, wherein the physical constants of the electric motor include stator winding resistance, stator winding inductance, flux leakage, inertia of rotor and load, and a coefficient of viscous friction.

4. The reconfiguration system of clause 1, wherein the electric motor controller includes a Clarke transformation converter including circuitry, the converter configured to convert sensed three-phase currents into the sensed current values comprising $\alpha\beta$-axis stationary stator current values, and wherein the estimated current values comprise estimated $\alpha\beta$-axis stationary stator current values.

5. The reconfiguration system of clause 1, wherein the failure detector comprises:

adder circuitry configured to determine a residual value between at least one sensed current value and at least one estimated current value;

comparator circuitry configured to compare the residual value with a threshold value to determine an error value; and

selection circuitry configured to select the sensed current values for determining the feedback current values when the error value does not indicate a failure, and to select the estimated current values for determining the feedback current values when the error value indicates a failure.

6. The reconfiguration system of clause 1, wherein the estimated and sensed current values each comprise $\alpha\beta$-axis stationary stator current values including an $\alpha$ current value and a $\beta$ current value, and wherein the failure detector comprises:

a first adder configured to subtract an estimated $\alpha$ current value from a sensed $\alpha$ current value to determine an $\alpha$ residual value;

a second adder configured to subtract an estimated $\beta$ current value from a sensed $\beta$ current value to determine a $\beta$ residual value;

a first comparator configured to compare the $\alpha$ residual value with an $\alpha$ threshold value to determine an $\alpha$ error value;

a second comparator configured to compare the $\beta$ residual value with a $\beta$ threshold value to determine a $\beta$ error value; and

selection circuitry configured to select the sensed current values for determining the feedback current values when the $\alpha$ and $\beta$ error values do not indicate a failure, and to select the estimated current values for determining the feedback current values when either one or both of the $\alpha$ and $\beta$ error values indicate a failure.

7. A method for estimating current values in an electric motor controller including a control loop including a current sensor configured to sense phase current signals driving an electric motor and to provide sensed current values used in the control loop for generating the phase current signals, the method comprising:

receiving, by an input interface including circuitry, a sensed angular speed value, a sensed angular position value, and a plurality of physical parameters of the electric motor;

developing, by the control loop including circuitry, a pair of control voltages; and

calculating, by a linear parameter-varying (LPV) observer including circuitry, estimated current values indicative of the sensed current values using the sensed angular speed value, the sensed angular position value, the pair of control voltages, and the plurality of physical parameters of the electric motor.

8. The method of clause 7, wherein the calculating by an LPV observer comprises combining the pair of control voltages, the sensed angular speed value, the sensed angular position value, the plurality of physical parameters and gain information to calculate the estimated current values.

9. The method of clause 7, wherein the receiving comprises receiving a plurality of physical parameters of the electric motor including stator winding resistance, stator winding inductance, flux leakage, inertia of rotor and load, and a coefficient of viscous friction of the electric motor.

10. The method of clause 7, further comprising:

performing a Clarke transformation to convert sensed three-phase currents into the sensed current values comprising $\alpha\beta$-axis stationary stator current values; and

wherein the calculating estimated current values comprises calculating estimated $\alpha\beta$-axis stationary stator current values.

11. The method of clause 7, further comprising:

comparing the sensed current values with the estimated current values for detecting a failure; and

substituting the estimated current signals for the sensed current signals when a failure is detected.

12. A linear parameter-varying (LPV) observer for an electric motor controller, the electric motor controller including a control loop with a current sensor configured to sense phase current signals driving an electric motor and to provide sensed current values used in the control loop, the LPV observer comprising:

an input interface for providing a sensed angular speed value, a sensed angular position value, and a plurality of physical parameters of the electric motor, and for providing a pair of control voltages in the control loop used for generating the phase current signals; and

an LPV processor including circuitry, the LPV processor configured to calculate estimated current values indicative of the sensed current values using the sensed angular speed value, the sensed angular position value, the pair of control voltages, and the plurality of physical parameters of the electric motor.

13. The LPV observer of clause 12,

wherein the input interface provides trigonometric angular position values comprising a sine function of the sensed angular position value and a cosine function of the sensed angular position value; and

wherein the plurality of physical parameters of the electric motor includes a stator winding inductance, a stator winding resistance, flux leakage, and inertia of rotor and load.

14. The LPV observer of clause 13, wherein the LPV processor comprises:

a first adder configured to subtract an estimated angular speed value from the sensed angular speed value and to subtract an estimated angular position value from the sensed angular position value to provide an angular speed and position difference value;

a first gain block configured to combine the angular speed and position difference value with a gain-scheduling value of the angular position using the trigonometric angular position values to calculate a first add value;

a second gain block configured to combine the pair of control voltages with the stator winding inductance to provide a second add value;

a third gain block configured to combine estimated current values with the stator winding inductance and the stator winding resistance to provide a third add value;

a fourth gain block configured to combine the estimated angular speed value with the flux leakage, the stator winding inductance, and the trigonometric angular position values to provide a fourth add value;

at least one second adder configured to add the first add value, the second add value, the third add value, and the fourth add value to provide a derivative of the estimated current values;

a first integrator that integrates the derivative of the estimated current values to provide the estimated current values;

a fifth gain block configured to combine the estimated current values with the flux leakage, the inertia of rotor and load, and the trigonometric angular position values to provide a fifth add value;

a sixth gain block configured to combine the estimated angular speed value with a coefficient of viscous friction and the inertia of rotor and load to provide a sixth add value;

a third adder configured to add the first add value, the fifth add value, and the sixth add value to provide a derivative of the estimated angular speed value; and

a second integrator configured to integrate the derivative of the estimated angular speed value to provide the estimated angular speed value, and a third integrator configured to integrate the estimated angular speed value to provide the estimated angular position value.

15. The LPV observer of clause 14, wherein the sensed angular speed value is a value $\omega_e$, wherein the sensed angular position value is a value $\theta_e$, wherein the estimated angular speed value is a value $\hat{\omega}_e$, wherein the estimated angular position value is a value $\hat{\theta}_e$, wherein the angular speed and position difference value comprises a value $\begin{bmatrix} \omega_e - \hat{\omega}_e \\ \theta_e - \hat{\theta}_e \end{bmatrix}$ = $\Delta$, wherein the gain-scheduling value is a value $K(\theta_e) = K_1 \sin \theta_e + K_2 \cos \theta_e + K_3$ wherein $K_1$, $K_2$, and $K_3$ are gain values, and wherein the first add value comprises a value $K(\theta_e) \Delta_{\omega_e, \theta_e}$ .

16. The LPV observer of clause 14, wherein the stator winding inductance is a value $L_s$, wherein the pair of control voltages comprise values $U_\alpha$ and $U_\beta$ in an $\alpha\beta$-axis that are determined by subtracting the feedback current values from reference current values to provide corresponding error values, by applying the error values to proportional-integral controllers to provide stator reference direct and quadrature values, and by performing an inverse Park transformation conversion on the stator reference direct and quadrature values, and wherein the second add value is $\frac{1}{L_s}\begin{bmatrix} u_\alpha(t) \\ u_\beta(t) \end{bmatrix}$ .

17. The LPV observer of clause 14, wherein the stator winding inductance is a value $L_s$, wherein the stator winding resistance is a value $R_s$, wherein the estimated current values comprise values $\hat{\imath}_\alpha$ and $\hat{\imath}_\beta$, and wherein the third add value comprises a value $\frac{R_s}{L_s}\begin{bmatrix} \hat{\imath}_\alpha \\ \hat{\imath}_\beta \end{bmatrix}$ .

18. The LPV observer of clause 14, wherein the estimated angular speed value is a value $\hat{\omega}_e$, wherein flux leakage comprises a value $\phi_m$, wherein the stator winding inductance is a value $L_s$, wherein the trigonometric angular position values comprise in $\theta_e$ and $\cos \theta_e$, and wherein the fourth add value comprises a value $\frac{p}{L_s}\phi_m\begin{bmatrix} \sin \theta_e \\ -\cos \theta_e \end{bmatrix}\hat{\omega}_e$ in which p is a poles pair value.

19. The LPV observer of clause 14, wherein the estimated current values comprise values $\hat{\imath}_\alpha$ and $\hat{\imath}_\beta$, wherein flux leakage comprises a value $\phi_m$, wherein the inertia of rotor and load comprises a value J, wherein the trigonometric angular position values comprise $\sin \theta_e$ and $\cos \theta_e$, and wherein the fifth add value comprises a value -

$-\frac{p}{J}\phi_m \sin \theta_e \, \hat{\imath}_\alpha + \frac{p}{J}\phi_m \cos \theta_e \, \hat{\imath}_\beta$ .

20. The LPV observer of clause 14, wherein the estimated angular speed value is a value $\hat{\omega}_e$, wherein the coefficient of viscous friction comprises a value $F_v$, wherein the inertia of rotor and load comprises a value J, and wherein the sixth add value comprises a value $\frac{F_v}{J}\hat{\omega}_e$ .

Although the present invention has been described in connection with several embodiments, the invention is not intended to be limited to the specific forms set forth herein. On the contrary, it is intended to cover such alternatives, modifications, and equivalents as can be reasonably included within the scope of the invention as defined by the appended claims. For example, variations of positive circuitry or negative circuitry may be used in various embodiments in which the present invention is not limited to specific circuitry polarities, device types or voltage or error levels or the like. For example, circuitry states, such as circuitry low and circuitry high may be reversed depending upon whether the pin or signal is implemented in positive or negative circuitry or the like. In some cases, the circuitry state may be programmable in which the circuitry state may be reversed for a given circuitry function.

The terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements.

**Claims**

1. A reconfiguration system for an electric motor controller, the electric motor controller including a control loop with a current sensor configured to sense phase current signals driving an electric motor to provide sensed current values used for determining feedback current values that are used to determine control voltages in the control loop for generating the phase current signals, and an angular speed and position sensor that provides angular speed and position information of the electric motor, the reconfiguration system comprising:

   a linear parameter-varying (LPV) observer including circuitry, the LPV observer configured to calculate estimated current values using the control voltages and the angular speed and position information; and
   a failure detector including circuitry, the failure detector configured to compare the sensed current values with the estimated current values for detecting a failure, and to substitute the estimated current signals for the sensed current signals when a failure is detected.

2. The reconfiguration system of claim 1, wherein the LPV observer is configured to combine the control voltages and the angular speed and position information with physical constants of the electric motor and gain information to calculate the estimated current values.

3. The reconfiguration system of claim 1 or 2, wherein the physical constants of the electric motor include stator winding resistance, stator winding inductance, flux leakage, inertia of rotor and load, and a coefficient of viscous friction.

4. The reconfiguration system of any preceding claim, wherein the electric motor controller includes a Clarke transformation converter including circuitry, the converter configured to convert sensed three-phase currents into the sensed current values comprising $\alpha\beta$-axis stationary stator current values, and wherein the estimated current values comprise estimated $\alpha\beta$-axis stationary stator current values.

5. The reconfiguration system of any preceding claim, wherein the failure detector comprises:

   adder circuitry configured to determine a residual value between at least one sensed current value and at least one estimated current value;
   comparator circuitry configured to compare the residual value with a threshold value to determine an error value; and
   selection circuitry configured to select the sensed current values for determining the feedback current values when the error value does not indicate a failure, and to select the estimated current values for determining the feedback current values when the error value indicates a failure.

6. The reconfiguration system of any preceding claim, wherein the estimated and sensed current values each comprise $\alpha\beta$-axis stationary stator current values including an $\alpha$ current value and a $\beta$ current value, and wherein the failure detector comprises:

   a first adder configured to subtract an estimated $\alpha$ current value from a sensed $\alpha$ current value to determine an $\alpha$ residual value;
   a second adder configured to subtract an estimated $\beta$ current value from a sensed $\beta$ current value to determine a $\beta$ residual value;
   a first comparator configured to compare the $\alpha$ residual value with an $\alpha$ threshold value to determine an $\alpha$ error value;
   a second comparator configured to compare the $\beta$ residual value with a $\beta$ threshold value to determine a $\beta$ error value; and
   selection circuitry configured to select the sensed current values for determining the feedback current values when the $\alpha$ and $\beta$ error values do not indicate a failure, and to select the estimated current values for determining the feedback current values when either one or both of the $\alpha$ and $\beta$ error values indicate a failure.

7. A method for estimating current values in an electric motor controller including a control loop including a current sensor configured to sense phase current signals driving an electric motor and to provide sensed current values used in the control loop for generating the phase current signals, the method comprising:

   receiving, by an input interface including circuitry, a sensed angular speed value, a sensed angular position value, and a plurality of physical parameters of the electric motor;

developing, by the control loop including circuitry, a pair of control voltages; and

calculating, by a linear parameter-varying (LPV) observer including circuitry, estimated current values indicative of the sensed current values using the sensed angular speed value, the sensed angular position value, the pair of control voltages, and the plurality of physical parameters of the electric motor.

8. The method of claim 7, wherein the calculating by an LPV observer comprises combining the pair of control voltages, the sensed angular speed value, the sensed angular position value, the plurality of physical parameters and gain information to calculate the estimated current values.

9. The method of claim 7 or 8, wherein the receiving comprises receiving a plurality of physical parameters of the electric motor including stator winding resistance, stator winding inductance, flux leakage, inertia of rotor and load, and a coefficient of viscous friction of the electric motor.

10. The method of any of the preceding claims 7 to 9, further comprising:

performing a Clarke transformation to convert sensed three-phase currents into the sensed current values comprising $\alpha\beta$-axis stationary stator current values; and

wherein the calculating estimated current values comprises calculating estimated $\alpha\beta$-axis stationary stator current values.

11. The method of any of the preceding claims 7 to 10, further comprising:

comparing the sensed current values with the estimated current values for detecting a failure; and

substituting the estimated current signals for the sensed current signals when a failure is detected.

12. A linear parameter-varying (LPV) observer for an electric motor controller, the electric motor controller including a control loop with a current sensor configured to sense phase current signals driving an electric motor and to provide sensed current values used in the control loop, the LPV observer comprising:

an input interface for providing a sensed angular speed value, a sensed angular position value, and a plurality of physical parameters of the electric motor, and for providing a pair of control voltages in the control loop used for generating the phase current signals; and

an LPV processor including circuitry, the LPV processor configured to calculate estimated current values indicative of the sensed current values using the sensed angular speed value, the sensed angular position value, the pair of control voltages, and the plurality of physical parameters of the electric motor.

13. The LPV observer of claim 12,

wherein the input interface provides trigonometric angular position values comprising a sine function of the sensed angular position value and a cosine function of the sensed angular position value; and

wherein the plurality of physical parameters of the electric motor includes a stator winding inductance, a stator winding resistance, flux leakage, and inertia of rotor and load.

14. The LPV observer of claim 12 or 13, wherein the LPV processor comprises:

a first adder configured to subtract an estimated angular speed value from the sensed angular speed value and to subtract an estimated angular position value from the sensed angular position value to provide an angular speed and position difference value;

a first gain block configured to combine the angular speed and position difference value with a gain-scheduling value of the angular position using the trigonometric angular position values to calculate a first add value;

a second gain block configured to combine the pair of control voltages with the stator winding inductance to provide a second add value;

a third gain block configured to combine estimated current values with the stator winding inductance and the stator winding resistance to provide a third add value;

a fourth gain block configured to combine the estimated angular speed value with the flux leakage, the stator winding inductance, and the trigonometric angular position values to provide a fourth add value;

at least one second adder configured to add the first add value, the second add value, the third add value, and the fourth add value to provide a derivative of the estimated current values;

a first integrator that integrates the derivative of the estimated current values to provide the estimated current values;

a fifth gain block configured to combine the estimated current values with the flux leakage, the inertia of rotor and load, and the trigonometric angular position values to provide a fifth add value;

a sixth gain block configured to combine the estimated angular speed value with a coefficient of viscous friction and the inertia of rotor and load to provide a sixth add value;

a third adder configured to add the first add value, the fifth add value, and the sixth add value to provide a derivative of the estimated angular speed value; and

a second integrator configured to integrate the derivative of the estimated angular speed value to provide the estimated angular speed value, and a third integrator configured to integrate the estimated angular speed value to provide the estimated angular position value.

15. The LPV observer of claim 14, wherein the sensed angular speed value is a value $\omega_e$, wherein the sensed angular position value is a value $\theta_e$, wherein the estimated angular speed value is a value $\hat{\omega}_e$, wherein the estimated angular position value is a value $\hat{\theta}_e$, wherein the angular speed and position difference value comprises a value

$$\begin{bmatrix} \omega_e - \hat{\omega}_e \\ \theta_e - \hat{\theta}_e \end{bmatrix} = \Delta_{\omega_e, \theta_e}$$, wherein the gain-scheduling value is a value $K(\theta_e) = K_1 \sin \theta_e + K_2 \cos \theta_e + K_3$ wherein

$K_1$, $K_2$, and $K_3$ are gain values, and wherein the first add value comprises a value $K(\theta_e) \Delta_{\omega_e, \theta_e}$.

FIG. 1

FIG. 2

FIG. 3

EP 4 708 668 A1

# EUROPEAN SEARCH REPORT

**Application Number**

EP 24 30 6478

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | VENGHI LUIS E ET AL: "Current-sensors fault tolerant control system for electric drives: experimental validation", 2021 XIX WORKSHOP ON INFORMATION PROCESSING AND CONTROL (RPIC), IEEE, 3 November 2021 (2021-11-03), pages 1-6, XP034058814, DOI: 10.1109/RPIC53795.2021.9648522 [retrieved on 2021-12-13] * abstract; figures 1-3; tables I,II * * page 1 - page 3 * ----- | 1-6,10, 11 | INV. H02P21/13 H02P29/024 H02P29/028 |
| X | YANG ZHIMIN ET AL: "LPV Model Based Sensor Fault Diagnosis and Isolation for Permanent Magnet Synchronous Generator in Wind Energy Conversion Systems", APPLIED SCIENCES, vol. 8, no. 10, 3 October 2018 (2018-10-03), page 1816, XP093247559, ISSN: 2076-3417, DOI: 10.3390/app8101816 | 7-9,12, 13 | |
| A | * abstract; figure 1 * * page 1 - page 10 * ----- | 2,3,14, 15 | **TECHNICAL FIELDS SEARCHED (IPC)** H02P |

The present search report has been drawn up for all claims

| Place of search | Date of completion of the search | Examiner |
|---|---|---|
| Munich | 12 February 2025 | Zeng, Wenyan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

    ...............................................................................

& : member of the same patent family, corresponding document

EPO FORM 1503 03.82 (P04C01)